# FASCICULE DE BREVET EUROPEEN

(11) **EP 4 133 558 B1**
(45) Date de publication et mention de la délivrance du brevet: **03.01.2024**
(21) Numéro de dépôt: 21715943.3
(22) Date de dépôt: 08.03.2021
(51) Int. Cl.: H01S 5/02, H01S 5/042, H01S 5/10, H01S 5/22, H01S 5/227, H01S 5/343

(54) **DISPOSITIF PHOTONIQUE POUR ETABLIR UN RAYONNEMENT LUMINEUX COMPRENANT UN MODE OPTIQUE DANS UN GUIDE D'ONDE**
FOTONISCHE VORRICHTUNG ZUR ERZEUGUNG VON LICHTSTRAHLUNG MIT EINEM OPTISCHEN MODUS IN EINEM WELLENLEITER
PHOTONIC DEVICE FOR PROVIDING LIGHT RADIATION COMPRISING AN OPTICAL MODE IN A WAVE GUIDE

(30) Priorité: 06.04.2020 FR 2003428
(43) Date de publication de la demande: 15.02.2023
(73) Titulaire: Scintil Photonics, 38040 Grenoble Cedex 9 (FR)
(72) Inventeur: MENEZO, Sylvie, 38500 Voiron (FR); THIESSEN, Torrey, Toronto, Ontario M5S 2P3 (CA)
(74) Mandataire: IP Trust
(86) Numéro de dépôt international: PCT/FR2021/050384
(87) Numéro de publication internationale: WO 2021/205086

(56) Documents cités:
- EP-A1- 3 340 403
- WO-A1-2018/115510
- WO-A1-2019/082817
- DE-A1-102017 113 389
- US-A1- 2018 026 111
- US-A1- 2018 323 575
- MARC SEIFRIED ET AL: "Monolithically Integrated CMOS-Compatible III-V on Silicon Lasers", IEEE JOURNAL OF SELECTED TOPICS IN QUANTUM ELECTRONICS., vol. 24, no. 6, 1 novembre 2018 (2018-11-01), pages 1-9, XP055756938, US ISSN: 1077-260X, DOI: 10.1109/JSTQE.2018.2832654 cité dans la demande

## Description

### DOMAINE DE L'INVENTION

Le domaine technique de l'invention est celui des composants photoniques intégrés qui utilisent à la fois les propriétés des matériaux semi-conducteurs aptes à émettre de la lumière et celles des matériaux semi-conducteurs utilisés classiquement dans les circuits intégrés implémentant des fonctions logiques et/ou analogiques. L'invention concerne plus particulièrement un dispositif photonique destiné à établir un rayonnement lumineux comprenant un mode optique dans un guide d'onde. Il peut notamment s'agir d'un laser hétérogène sur silicium.

### ARRIERE PLAN TECHNOLOGIQUE DE L'INVENTION

Un émetteur-récepteur optique est généralement formé de dispositifs optiques actifs (tel qu'un laser, un modulateur, une photodiode), et passifs (tels que des guides d'onde, des filtres optiques) éventuellement complétés de circuits électroniques. Ces blocs peuvent être intégrés dans un dispositif photonique en employant les technologies et les matériaux usuellement exploités pour la fabrication de circuits électroniques intégrés.

Dans un tel dispositif photonique, et de manière bien connue en soi, une région active formée d'un empilement de couches en matériaux III-V forment le milieu d'amplification optique d'un laser. Cette région active peut comprendre au moins un puits quantique, un point quantique ou une boite quantique, ou une pluralité de tels puits, points ou boites. Elle est constituée à partir de matériaux choisis dans la liste non exhaustive suivante : InP, AsGa, InGaAlAs, InGaAsP, InAsP, InAs.

Cette région active est disposée, prise en sandwich, entre une couche en matériau semi-conducteur de type N et une couche en matériau semi-conducteur de type P. Ces couches, typiquement à base d'InP ou d'AsGa permettent de faire circuler un courant dans la région active, et de pomper électriquement le milieu amplificateur afin de permettre la génération de lumière. Pour injecter et extraire des charges électriques dans la région active et permettre ce pompage, des plots métalliques électriquement conducteurs sont respectivement placés en contact ohmique avec les couches semi-conductrices de type P et de type N. Ces plots sont également électriquement reliés à des pistes d'interconnexions électriques, ces pistes permettant de faire circuler les charges dans le dispositif.

La région active est agencée au droit d'une portion d'un guide d'onde, formé par exemple en silicium, dite "portion hybride ». Le mode optique généré dans un tel agencement est dit « hybride », car il est partiellement localisé dans la région active et dans le guide d'onde. Le guide d'onde s'étend d'un côté au moins de la portion hybride de sorte à permettre la propagation du mode généré. Le document de M. Seifried et al., "Monolithically Integrated CMOS-Compatible III-V on Silicon Lasers," in IEEE Journal of Selected Topics in Quantum Electronics, vol. 24, no. 6, pp. 1-9, Nov.-Dec. 2018, Art no. 8200709 rappelle que plus le recouvrement du mode optique avec la zone d'injection du courant dans la région active est important, plus l'amplification est importante.

Pour permettre cet effet laser, le dispositif photonique comprend également une structure de rétroaction optique, permettant de former une cavité résonnante pour le milieu amplificateur. Cette structure peut être réalisée par un réflecteur distribué, par exemple un réseau de Bragg, agencé dans la région active ou, préférentiellement, dans le guide d'onde.

D'une manière générale, on s'intéresse à un rayonnement lumineux présentant une longueur d'onde utile dans le domaine d'application choisi. Ainsi, dans le domaine des télécoms une telle longueur d'onde est typiquement comprise entre 1200 et 1600nm. Les différents éléments du dispositif photonique qui vient d'être présenté sont configurés pour émettre un rayonnement dans la gamme de longueurs d'onde choisie.

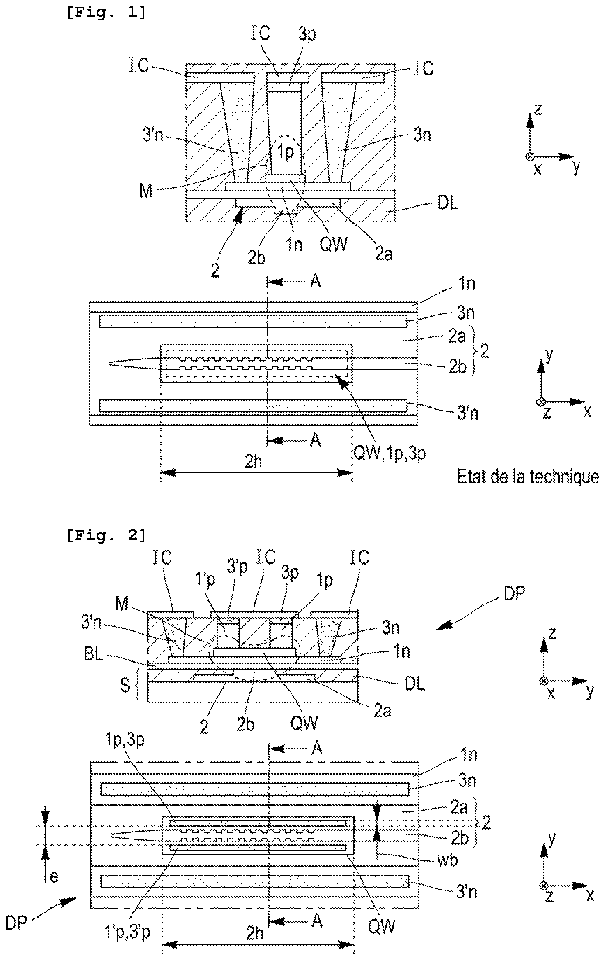

On a représenté sur la figure 1, un exemple de mise en oeuvre d'un dispositif photonique de l'état de la technique. Dans une couche mince DL, ici reposant un support non représenté, on a formé un guide d'onde 2 en silicium. Celui-ci s'étend longitudinalement dans un plan, selon une direction principale X, dans le repère (X, Y, Z) de la figure 1.

Le guide d'onde présente un profil (c'est-à-dire son contour dans un plan perpendiculaire à la direction principale de propagation de la lumière guidée) en arête. Il est donc composé d'un ruban 2a présentant une dimension latérale (selon la direction Y) étendue, et d'une nervure 2b dont la dimension latérale est plus réduite, disposée sous le ruban 2a et latéralement centrée sur ce ruban 2a. Les épaisseurs (selon la direction Z) du ruban 2a et de la nervure 2b sont chacune de l'ordre de 100 nm, et typiquement comprises entre 50 et 500nm. Une couche semi-conductrice de type N 1n est disposée sur la couche mince DL, en recouvrement du guide d'onde 2. Un isolant électrique, par exemple une couche d'oxyde de silicium, peut être prévu entre le guide d'onde 2 et la couche semi-conductrice de type N 1n. Cette couche 1n présente une épaisseur de l'ordre de 100 nm.

Sur la couche semi-conductrice de type N 1n, réside une région active QW sur laquelle repose une couche semi-conductrice de type P 1p. Cet ensemble est disposé, en contact avec la couche de type N 1n, au droit d'une portion hybride 2h du guide d'onde 2, et notamment au droit de la nervure 2b de ce guide d'onde 2. La portion hybride du guide d'onde est structurée afin de définir un réseau de Bragg définissant une structure de rétroaction optique du dispositif, par exemple par corrugation latérale du guide 2 comme cela est représenté sur la figure 1.

L'ensemble formé de la région active QW et de la couche semi-conductrice de type P 1p prend la forme d'un pavé, présentant une dimension latérale plus réduite que celle de la couche semi-conductrice de type N 1n, si bien qu'une portion libre de cette couche 1n, disposée de part et d'autre de la région active QW, n'est ni recouverte par la région active QW, ni recouverte par la couche semi-conductrice de type P 1p. La région active QW présente une épaisseur relativement faible de l'ordre de 200 nm et elle s'étend le long de la portion hybride 2h du guide d'onde qui peut présenter une distance longitudinale de l'ordre de 500 microns.

Sur la portion libre de la couche semi-conductrice de type N 1n, on a placé un plot métallique en contact ohmique avec cette couche, ici deux vias 3n, 3'n disposés de part et d'autre de la région active QW. Les vias métalliques 3n, 3'n, assurent la liaison électrique entre la couche semi-conductrice de type N 1n et des pistes d'interconnexion électriques IC qui surplombent l'ensemble. Similairement, un plot métallique 3p sous la forme d'un autre via est en contact ohmique avec la couche semi-conductrice de type P 1p, afin d'assurer la liaison électrique entre cette couche et une autre piste d'interconnexion IC (ces pistes ne sont pas représentées sur la vue de dessus de la figure 1 pour préserver la lisibilité de cette vue).

On a représenté en pointillés sur la coupe de la figure 1 le mode optique M généré par le dispositif photonique lorsqu'un courant est injecté dans la région active QW par l'intermédiaire de la couche semi-conductrice type P 1p. On observe que ce mode présente une étendue très importante dans une direction perpendiculaire au plan (X,Y) dans lequel est défini le guide d'onde. Pour éviter que ce mode n'intercepte les éléments métalliques du dispositif, notamment le deuxième plot métallique 3p, l'épaisseur de la couche de type P 1p est particulièrement importante, supérieure au micron et jusqu'à plusieurs microns. On écarte de la sorte suffisamment les plots métalliques 3n, 3'n, 3p de la région active QW et on évite ainsi l'absorption du rayonnement lumineux dans le métal constituant les plots.

Cette configuration n'est toutefois pas avantageuse. Elle nécessite d'abord une épaisseur importante de matériau formant la couche semi-conductrice de type P 1p, ce qui n'est pas favorable lors de la fabrication du dispositif photonique. En effet, la gravure de cette épaisseur importante est longue, elle génère également une topologie de surface élevée, ce qui est gênant pour la suite des opérations de fabrication, notamment pour la formation des plots métalliques. Par ailleurs, la couche semi-conductrice de type P 1p, typiquement formée d'InP par exemple dopé au zinc à environ 2^{E}18 at/cm3, présente un facteur d'absorption (notamment dans la gamme de longueurs d'onde utiles dans le domaine des télécommunications optiques) particulièrement important, de l'ordre de -40 à -70 dB/cm. Ce facteur est à comparer à celui d'une couche semi-conductrice de type N, à base d'InP N par exemple dopé en soufre à 2^{E}18/cm3, de l'ordre de -15 dB/cm et à celui du silicium, de l'ordre de -2 dB/cm.

Ainsi, l'architecture du dispositif photonique représenté sur la figure 1 n'est pas optimale, car d'une part le rayonnement produit est absorbé en grande partie dans la couche semi-conductrice de type P 1p, et d'autre part sa fabrication est délicate lorsque l'on vise à fournir une surface plane.

Pour remédier à cela, ce document précité propose de fournir une région active QW et une couche semi-conductrice de type P 1p dont les dimensions latérales, selon la direction Y, est étendue, ce qui permet d'élargir le mode optique généré selon cette direction et de l'aplatir dans la direction Z, perpendiculaire au plan dans lequel le guide d'onde 2 est défini. Pour que l'injection du courant, donc le pompage électrique, soit bien en recouvrement avec le mode optique, cette solution nécessite la présence de couches bloquantes latérales disposées entre la région active QW et la couche semi-conductrice de type P 1p. L'injection de courant est donc localisée au centre de la structure, car bloquée latéralement par les couches bloquantes. De la sorte, le rayonnement lumineux présente un mode qui ne s'étend pas jusqu'aux métaux formant les plots métalliques. L'inconvénient de cette méthode est qu'elle nécessite une reprise d'épitaxie pour former la couche semi-conductrice de type P 1p en recouvrement des couches bloquantes latérales. Cette étape s'effectue à très haute température, engendrant des contraintes dans la région active QW ce qui conduit à la dégrader.

La présente invention vise à fournir une solution alternative à celle de l'état de la technique pour remédier aux problèmes posés par la présence d'une couche de type P impérativement épaisse.

### BREVE DESCRIPTION DE L'INVENTION

En vue de la réalisation de l'un de ces buts, l'objet de l'invention propose un dispositif photonique pour établir un rayonnement lumineux comprenant un mode optique dans un guide d'onde, le dispositif comprenant :
- un guide d'onde s'étendant dans un plan selon une direction principale de propagation du mode optique ;
- une couche en matériau semi-conducteur de type N disposée en recouvrement du guide d'onde ;
- une région active formée d'un empilement de couches en matériaux III-V, la région active étant disposée sur, et en contact avec, une portion de la couche de type N au droit d'une portion du guide d'onde, une autre portion de la couche de type N, dite portion libre, n'étant pas en contact avec la région active ;
- une pluralité de piliers en matériau semi-conducteur de type P disposés sur, et en contact avec, la région active, le matériau semi-conducteur de type P présentant un premier indice optique et les piliers de type P étant séparés les uns des autres par un matériau d'encapsulation présentant un deuxième indice optique, inférieur au premier ;
- au moins un premier plot métallique en contact ohmique avec la portion libre de la couche de type N et au moins un second plot métallique en contact ohmique avec les piliers de type P.

En réalisant la couche de type P sous la forme d'une pluralité de piliers séparés latéralement les uns des autres par un matériau d'encapsulation de plus faible indice optique, on peut façonner le mode optique généré par le dispositif photonique, pour éviter qu'il ne s'étende (ou limiter cette étendue) selon la direction Z, perpendiculairement au plan dans lequel réside le guide d'onde, en recouvrement des plots métalliques dans lequel il serait fortement absorbé. On peut dans le même temps limiter l'épaisseur des piliers de type P comparé à l'épaisseur d'une couche de type P de l'état de la technique et sans nécessiter de couche bloquante. On augmente de la sorte l'efficacité du dispositif photonique.

Selon d'autres caractéristiques avantageuses et non limitatives de l'invention, prises seules ou selon toute combinaison techniquement réalisable :
- le guide d'onde est configuré pour former une structure de rétroaction optique ;
- la structure de rétroaction optique est un réseau de Bragg à corrugation latérale ou à corrugation verticale ;
- le dispositif photonique comprend une couche d'assemblage en un matériau diélectrique disposée entre la couche de type N et le guide d'onde ;
- le dispositif photonique comprend au moins trois piliers de type P ;
- au moins un des piliers de type P n'est pas en contact ohmique avec un second plot métallique ;
- le matériau d'encapsulation comprend de l'air, du dioxyde de silicium, du nitrure de silicium ou de l'oxyde d'aluminium ;
- les piliers de type P présentent des largeurs différentes ou sont séparés latéralement les uns des autres par des espacements différents ;
- un pilier de type P est disposé au droit d'une zone latéralement centrée de la région active ;
- les piliers de type P présentent une hauteur inférieure à 1 micron ;
- la couche active présente une largeur comprise entre 0,5 et 5 microns ;
- le dispositif photonique comprend deux premiers plots métalliques disposés de part et d'autre de la région active QW ;
- la région active comprend une zone endommagée disposée entre deux piliers de type P.

### BREVE DESCRIPTION DES DESSINS

D'autres caractéristiques et avantages de l'invention ressortiront de la description détaillée de l'invention qui va suivre en référence aux figures annexées sur lesquels :
- La figure 1 représente un dispositif photonique de l'état de la technique ;
- La figure 2 représente un premier mode de mise en oeuvre d'un dispositif photonique DP conforme à l'invention ;
- Les figures 3a à 3c représentent trois architectures simulées de dispositifs photoniques rendant apparents les avantages d'un dispositif photonique conforme à l'invention.
- La figure 4 représente les pertes par absorption dans des plots métalliques de trois architectures simulées, selon l'épaisseur de matériau semi-conducteur de type p.
- La figure 5 présente une synthèse des résultats des simulations qui ont été conduites dans le cadre de la préparation de la présente invention.
- Les figures 6 et 7 présentent d'autres modes de mise en oeuvre d'un dispositif photonique conforme à l'invention.

### DESCRIPTION DETAILLEE DE L'INVENTION

Par souci de simplification de la description à venir, les mêmes références sont utilisées pour des éléments identiques ou assurant la même fonction dans l'état de la technique ou dans les différents modes de mise en oeuvre exposés du dispositif photonique.

On a représenté sur la figure 2 un premier mode de mise en oeuvre d'un dispositif photonique DP conforme à la présente description.

Dans un substrat S, qui peut être un substrat du type silicium sur isolant, réside un guide d'onde 2 en silicium disposé dans une couche mince DL de ce substrat S. Le guide d'onde 2 s'étend longitudinalement selon une direction principale (la direction X sur la figure 2) par exemple pour acheminer la lumière vers d'autres composants du dispositif photonique 1, par exemple un modulateur. Le guide d'onde 2 est composé dans l'exemple de la figure 2 d'un ruban 2a. Il présente une largeur maximale (selon la direction Y, transversale à la direction principale) qui peut être comprise entre 2 et 500 microns. Le guide d'onde représenté est également composé d'une nervure 2b, latéralement centrée sur le ruban 2a, et qui s'étend d'une extrémité à l'autre de ce ruban 2a selon la direction principale. La nervure 2b peut présenter une largeur comprise entre 0,05 et 20 microns. Le guide d'onde présente une épaisseur (selon la direction Z) qui peut être comprise entre 5nm et 5 microns.

La combinaison du ruban 2a et de la nervure 2b constitue dans cet exemple un guide d'onde 2 dont le profil est en arête. Il est structuré de manière bien connue en soi, pour former une structure de rétroaction optique. Comme cela est visible sur la vue de dessus de la figure 2, le guide d'onde 2 est ici configuré sous la forme d'un réseau de Bragg à corrugation latérale, mais on aurait pu prévoir que le réseau soit à corrugation verticale, voire même d'intégrer la structure de rétroaction optique dans le milieu d'amplification optique du dispositif photonique DP.

Le guide d'onde 2 est noyé dans un matériau diélectrique, typiquement du dioxyde de silicium, le confinement optique dans le guide 2 étant obtenu par la différence d'indice optique entre le silicium du guide d'onde 2 et le matériau diélectrique de plus faible indice optique que celui du silicium. L'ensemble composé du diélectrique et du guide d'onde 2 forme la couche mince DL du substrat S.

Bien entendu l'invention n'est nullement limitée à un guide d'onde 2 de la forme représentée sur la figure 2, et celui-ci peut présenter un contour différent de celui pris ici en exemple. Il n'est pas nécessaire non plus que le substrat S soit du type silicium sur isolant, bien que l'emploi d'un tel substrat facilite grandement la fabrication du guide d'onde 2. Il n'est pas nécessaire non plus que le guide d'onde 2 soit constitué de silicium. A titre d'exemple, on peut envisager que le guide d'onde 2 soit formé en nitrure de silicium déposé sur un substrat de silicium présentant une couche d'oxyde superficielle, le guide d'onde en nitrure étant encapsulé par une couche déposée d'oxyde de silicium. Aussi, il n'est pas nécessaire que le guide d'onde soit entièrement encapsulé par un matériau diélectrique, et on peut prévoir que la couche mince DL présente une topologie de surface conduisant à former des cavités dans la structure lorsque le dispositif photonique DP est complété, comme cela est par exemple le cas dans le document US8110823.

Poursuivant la description du mode de mise en oeuvre de la figure 2, le guide d'onde 2 est surmonté par une structure émettrice composée d'une région active QW prise en sandwich entre des couches en matériau semi-conducteur de type N 1n et de type P 1p.

Plus précisément, le dispositif photonique de la figure 2 comprend une couche en matériau semi-conducteur de type N 1n disposée en recouvrement du guide d'onde 2, c'est-à-dire s'étendant latéralement de part et d'autre de ce guide sur une partie au moins de sa longueur. Elle présente une largeur typiquement comprise entre 20 et 200 microns (suivant la direction Y). La couche en matériau semi-conducteur de type N peut être formée d'InP dopé au soufre et elle peut présenter une épaisseur généralement comprise entre 50 et 500nm, lorsque le guide d'onde 2 est en silicium. La couche en matériau semi-conducteur de type N 1n peut être en contact direct avec le guide d'onde 2, plus généralement avec la couche mince DL, ou on peut prévoir comme c'est le cas sur la figure 2, une couche d'assemblage BL entre la couche mince DL et la couche en matériau semi-conducteur de type N 1n. Cette couche d'assemblage est préférentiellement mince, d'épaisseur comprise entre quelques nanomètres et 150nm.

Par souci de concision, on désignera dans la suite de cette description la couche en matériau semi-conducteur de type N par l'expression « couche de type N », étant entendu que cette couche est constituée d'un matériau semi-conducteur.

Sur la couche de type N 1n, réside une région active QW formée d'un empilement en matériaux III-V. La région active QW est disposée sur et en contact avec une portion seulement de la couche de type N 1n, au droit d'une portion longitudinale 2h du guide d'onde 2, dite portion hybride. Une portion dite « libre » de la couche de type N 1n n'est donc pas en contact avec la couche active QW et cette portion libre ici disposée latéralement de part et d'autre de la région active QW peut être exploitée pour y former des contacts ohmiques.

La région active QW présente une épaisseur généralement comprise entre 10 et 500nm, typiquement de l'ordre de 50nm, et elle s'étend le long de la portion hybride 2h du guide d'onde 2 sur une longueur typiquement comprise entre 100 et 2000 microns. Elle présente une largeur qui peut être comprise entre 0,5 et 30 microns, par exemple égale à 5 microns.

Le dispositif photonique DP conforme à la présente description comprend également au moins un premier plot métallique en contact avec la portion libre de la couche de type N 1n. Dans l'exemple représenté, deux vias 3n, 3'n emplis d'un matériau métallique, par exemple du tungstène, sont disposés de part et d'autre de la couche active QW. Ces vias métalliques assurent la liaison électrique entre la couche de type N 1n et des pistes d'interconnexion IC du dispositif photonique DP (non représentées sur la vue de dessus de la figure 2 pour préserver la lisibilité de cette vue).

Enfin, le dispositif photonique DP de la figure 2 comprend une pluralité de piliers en matériau semi-conducteur de type P 1p disposés sur, et en contact avec, la région active QW. Ces piliers seront désignés par l'expression « piliers de type P » dans la suite de cette description, étant entendu qu'ils sont constitués dans tous les cas d'un matériau semi-conducteur. Ainsi, on a représenté sur cette figure un premier pilier de type P 1p d'InP dopé P agencé le long d'un premier côté de la région active QW et un second pilier de type P 1'p agencé le long de l'autre côté de cette région. Les faces inférieures de ces piliers 1p, 1'p sont en contact avec la région active QW et les faces supérieures sont respectivement en contact ohmique avec des seconds plots métalliques 3p, 3'p. Les piliers de type P 1p, 1'p sont séparés l'un de l'autres par un matériau d'encapsulation présentant un indice optique inférieur à celui du matériau semi-conducteur dont sont formés les piliers. Il peut ainsi s'agir d'un matériau diélectrique à base d'oxyde de silicium, de nitrure de silicium, d'un diélectrique polymère à base de benzocyclobutène, voire même d'air. Dans tous les cas, le matériau semi-conducteur dont sont formés les piliers de type P présente un premier indice optique, et le matériau d'encapsulation séparant les piliers de type P présente un deuxième indice, inférieur au premier.

Un tel arrangement en piliers de type P permet de façonner le mode optique généré par le dispositif photonique, pour éviter qu'il ne s'étende (ou limiter cette étendue) selon la direction Z, perpendiculairement au plan dans lequel réside le guide d'onde 2.

Les piliers de type P 1p et 1'p s'étendent sur toute la longueur de la région active QW, ou pour le moins sur une majeure partie de cette longueur. La largeur de chaque pilier Wb et l'espacement e entre chaque pilier 1p, 1'p sont bien entendu dépendants de la largeur de la couche active QW et du nombre de piliers. Il n'est pas nécessaire que la largeur d'un pilier ou que l'espacement entre deux piliers soient tous identiques. A titre d'exemple, et selon la largeur de la région active QW sur laquelle il repose, un pilier peut présenter une largeur Wb comprise entre 0,5 et 3 microns et l'espacement e entre deux piliers peut être compris entre 0,1 et 2 microns.

Comme on l'a déjà évoqué, la couche de type N 1n, la région active QW et les piliers de type P 1p sont noyés dans un matériau d'encapsulation, typiquement un oxyde de silicium. Les premiers et seconds plots métalliques sont aménagés dans ce matériau, pour relier électriquement les différents éléments aux pistes d'interconnexion électriques IC disposées sur le matériau d'encapsulation et qui surplombent l'ensemble.

Le mode optique M généré de manière hybride dans la couche active QW et dans le guide d'onde 2 par le dispositif photonique DP représenté sur la figure 2 est représenté en pointillé sur la coupe transversale de cette figure. La pluralité de piliers de type P 1p, 1'p permet de façonner ce mode optique M, pour qu'il s'étende de manière privilégiée latéralement, selon la direction Y de la figure 2, et éviter qu'il ne s'étende selon la direction Z, perpendiculaire au plan dans lequel réside la région active QW. On réduit de la sorte le risque que ce mode optique ne recouvre les zones métalliques et notamment les plots métalliques 3p, 3'p en contact ohmique avec les piliers de type P 1p, 1'p.

D'une manière générale, le nombre de piliers de type P, la largeur Wb de ces piliers et l'espacement e entre deux piliers de type P sont adaptés à la largeur du guide d'onde 2. Ils sont choisis pour façonner la forme du mode optique hybride afin qu'il s'étende préférentiellement latéralement.

Ainsi, on peut réduire, la hauteur de ces piliers 1p, 1'p en comparaison avec l'épaisseur de 1 ou 2 microns ou plus rencontrée dans les dispositifs de l'état de la technique. Cette caractéristique est particulièrement avantageuse, car le matériau semi-conducteur de type P formant ces piliers présente un facteur d'absorption optique particulièrement important. La structure étant exempte de toute couche de blocage, la formation de ces piliers est aisée à mettre en oeuvre, elle ne nécessite pas d'étape de reprise d'épitaxie, et on peut aisément fournir un dispositif photonique présentant une surface plane. Comme cela sera rendu apparent dans les résultats présentés dans la section suivante de cette description, il est possible de former des piliers de type P 1p, 1'p qui présentent une hauteur inférieure à 1 micron, voire même à 500nm, ou 300nm tout en limitant les pertes par absorption dans les plots métalliques en dessous de 0,1 dB.

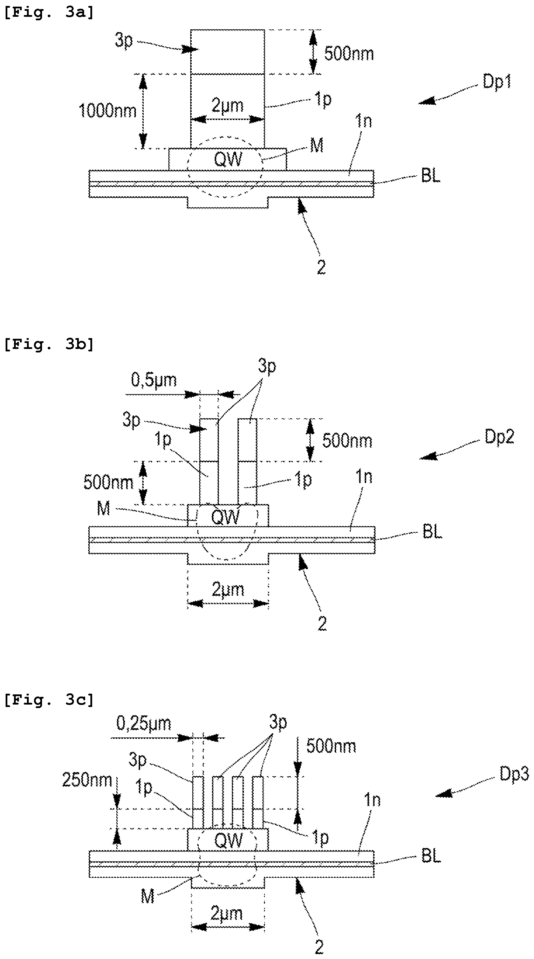

Pour montrer tout le bénéfice obtenu en remplaçant la couche continue de type P de l'état de la technique par une pluralité de piliers de type P 1p, 1'p, séparés par un matériau d'encapsulation d'indice plus faible, la demanderesse a procédé à la simulation de plusieurs structures DP1, DP2, DP3 dont les architectures sont représentées sur les figures 3a à 3c.

La première structure DP1 de la figure 3a correspond à un dispositif photonique de l'état de la technique formé à base d'InP. La couche active QW s'étend sur une largeur de 3 microns. La couche continue en InP de type P 1p, centrée sur la couche active et au droit de la nervure du guide d'onde 2, présente une largeur de 2 microns. Cette couche, d'une épaisseur de 1 micron, est surmontée par un plot métallique 3p de 500nm. Une couche d'assemblage BL est disposée entre la couche de type N 1n et le guide d'onde 2.

La deuxième structure DP2 de la figure 3b est conforme à l'invention. La région active QW présente une largeur de 2 microns et surplombe la nervure du guide d'onde 2. On a prévu dans cette seconde structure DP2, deux piliers de type P 1p en InP dopé P de 0,5 micron de largeur Wb chacun, et espacés d'une distance e de 0,5 micron également. Les piliers de type P sont disposés chacun à 0,25 micron du bord de la couche active QW. Les deux piliers de type P 1p de cette deuxième structure présentent une hauteur de 500 nm.

La troisième structure DP3 de la figure 3c est également conforme à l'invention et similaire à celle de la deuxième structure DP2, mais munie cette fois de quatre piliers de type P en InP dopé P présentant chacun 0,25 micron de largeur. Ils sont espacés les uns des autres d'une distance e de 0,25 micron. Les quatre piliers de type P 1p de cette troisième structure DP3 présentent une hauteur de 250 nm.

Pour chacune de ces structures, on a mesuré par simulation le recouvrement du mode optique généré M avec les différents éléments qui les composent (guide d'onde 2, région active QW, couche ou pilier de type P 1p). Le tableau ci-dessous résume les résultats obtenus.

**[Table 1]**

| Structur e | Epaisseur SC type P | Proportion du mode optique dans le guide d'onde | Proportion du mode optique dans la région active | Proportion du mode optique dans le pilier de Type P |
|---|---|---|---|---|
| DP1 | 1000 | 7,9% | 28% | 16,3% |
| DP2 | 500 | 24,5% | 24,3% | 5,7% |
| DP3 | 250 | 28,2% | 22,5% | 3 % |

On observe qu'en introduisant des piliers séparés par le matériau d'encapsulation dans l'architecture du dispositif, on parvient à confiner une portion croissante du mode M dans le guide d'onde 2 et dans la région active QW. On limite dans le même temps le recouvrement de ce rayonnement avec le matériau de semi-conducteur de type P formant la couche continue de la première structure DP1 ou les piliers de type P des deuxième et troisième structures DP2, DP3. On rappelle que l'InP dopé P présente un facteur d'absorption du rayonnement lumineux de l'ordre de 50dB/cm, que la région active QW lorsqu'elle est formée à base d'InN présente un facteur d'absorption de l'ordre de 15dB/cm et le guide d'onde en silicium un facteur de l'ordre de 2dB/cm. Il est donc très avantageux de limiter le recouvrement du rayonnement généré avec le matériau semi-conducteur de type P, comme cela est observé lorsque ce matériau est configuré sous la forme de piliers.

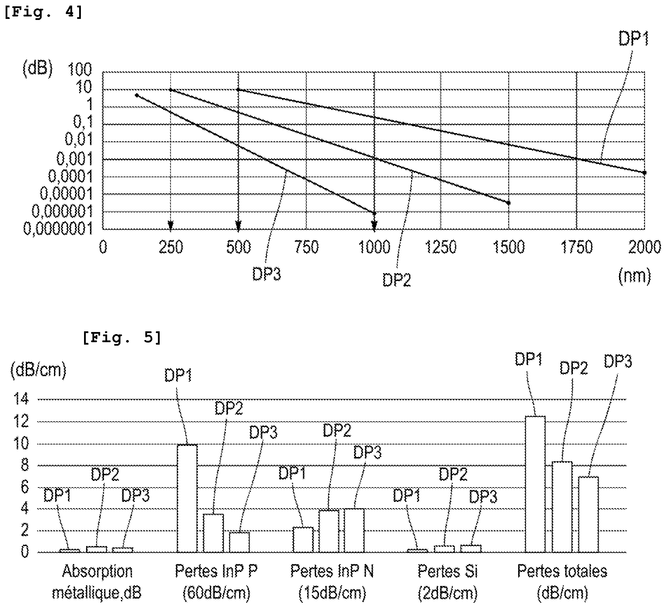

Dans une seconde série de simulations, on a fait varier, pour chacune des trois structures DP1, DP2, DP3, la hauteur des piliers en InP dopé P 1p. On a ensuite estimé les pertes par absorption dans les plots métalliques 3p surplombant le matériau semi-conducteur dopé P, en fonction de cette épaisseur. Le graphe de la figure 4 présente ces résultats. On a disposé selon l'axe des abscisses de ce graphe l'épaisseur, en nm, de matériau semi-conducteur de type P formant les piliers 1p de la première structure DP1 ou les piliers de type P 1p des deuxième et troisième structures DP2, DP3. En ordonnée, on a disposé les pertes par absorption (en dB) dans les plots métalliques 3p de ces structures. On observe sur ce graphe que pour réduire ces pertes sous un niveau de 0,1 dB dans une structure conventionnelle telle que la première structure DP1, il faut prévoir plus de 1 micron d'épaisseur pour la couche de type P 1p comme cela a été rapporté dans la présentation de l'état de la technique. Pour les structures conformes à l'invention DP2, DP3, cette épaisseur de matériau semi-conducteur peut être réduite à moins de 650nm lorsque l'on a prévu deux piliers de type P 1p comme dans la deuxième structure DP2 et peut être réduite à moins de 300nm lorsque l'on a prévu quatre piliers de type P 1p comme dans le cas de la troisième structure DP3.

Enfin, la figure 5 présente une synthèse des résultats des simulations qui ont été conduites et compare, pour chacune des trois structures DP1, DP2, DP3 représentées sur les figures 3a à 3b, les pertes par absorption. Comme cela est visible sur cette figure 5, chacune des structures DP1, DP2, DP3 présente une épaisseur suffisante de matériau semi-conducteur de type P pour limiter les pertes par absorption dans les plots métalliques 3p, si bien que ces pertes sont limitées pour chacune de ces structures, bien inférieures à 1dB/cm. Dans le cas de la première structure DP1 pour lequel le mode optique généré s'étend largement dans le matériau de type P, relativement épais, les pertes par absorption dans ce matériau approchent les 10dB/cm. Ce n'est pas le cas dans les deuxième et troisième structures DP2, DP3 ou l'étalement du mode optique et l'épaisseur réduite de matériau semi-conducteur de type P dans les piliers 1p limitent les pertes par absorption dans ce matériau à moins de 5dB/cm.

Lorsque l'on observe les pertes totales représentées sur cette figure 5, on mesure tout l'intérêt de l'invention.

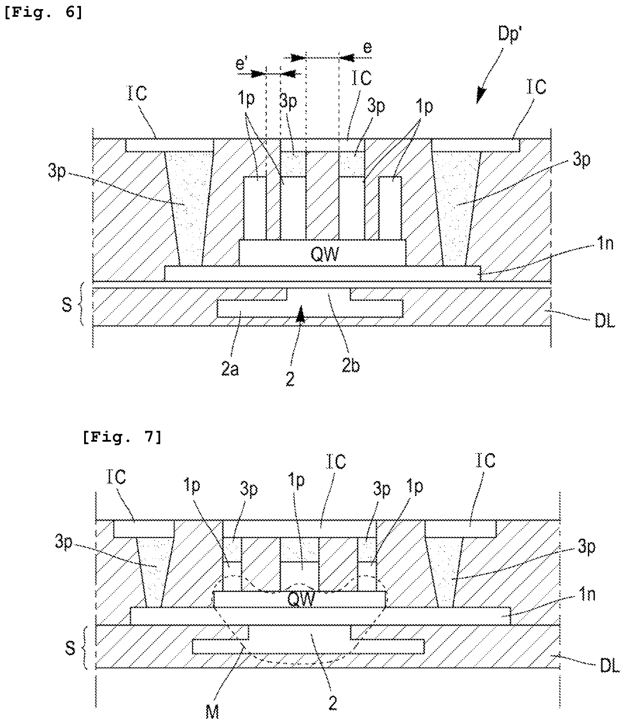

On peut apporter de nombreuses variantes au mode de mise en oeuvre représenté sur la figure 2 sans sortir du cadre de la présente description. Ainsi, et comme on l'a déjà noté en relation avec la présentation des résultats de simulation, il peut être avantageux de prévoir plus de deux piliers de type P 1p, 1'p. On pourra ainsi prévoir un nombre quelconque de piliers de type P 1p, pair ou impair, par exemple 3, 4, 5 ou plus. Il peut être avantageux de disposer un pilier de type P sensiblement centré, selon la direction Y, sur la région active QW. On favorise de la sorte l'évacuation de la chaleur, par conduction thermique dans le pilier, cette chaleur étant générée de manière marquée dans cette zone centrale de la région active QW. Cela pourra être par exemple réalisé en choisissant un nombre impair de piliers de type P 1p, un des piliers étant alors disposé au droit de cette zone centrale. Cette configuration est celle représentée dans l'exemple de la figure 7, mais bien entendu d'autres configurations sont possibles.

Comme on l'a déjà dit également, les piliers peuvent présenter une largeur Wb et un espacement e entre eux variables. On peut également prévoir, lorsque l'on a prévu au moins 3 piliers de type P 1p, qu'une pluralité seulement de ces piliers 1p soit en contact électrique avec au moins un deuxième plot métallique, les piliers de type P 1p restants n'étant alors pas reliés électriquement aux pistes d'interconnexion IC. En fournissant des piliers non électriquement reliés en matériau semi-conducteur noyés dans le matériau d'encapsulation, on aide à confiner le mode lumineux M et à le conformer pour qu'il s'étale latéralement.

On a ainsi représenté sur la figure 6 une vue en coupe d'un dispositif photonique DP' présentant 4 piliers de type P 1p. Les piliers de type P extérieurs ne sont pas reliés à un deuxième plot métallique 3p et donc aux pistes d'interconnexion IC. La distance e séparant les piliers de type P centraux est plus importante que la distance e' séparant un pilier extérieur d'un pilier central.

D'une manière générale, on pourra se faire aider de moyens usuels de simulation pour déterminer les paramètres géométriques de la pluralité de piliers de type P, leur nombre et leurs emplacements relatifs pour donner au mode optique une forme qui convient.

On peut également prévoir que le guide d'onde 2 soit retourné par rapport à sa disposition de la figure 2, comme cela est le cas du dispositif photonique DP' représenté sur la figure 6. Dans une telle configuration, le ruban 2a est disposé entre la couche de type N 1n et la nervure 2b. La couche d'assemblage BL du dispositif photonique DP' de la figure 6 est optionnelle.

Pour aider au confinement du mode optique et à le façonner pour qu'il s'étende principalement latéralement, on peut prévoir d'endommager une partie de la région active QW, notamment dans une portion de cette région QW qui n'est pas surplombée par un pilier de type P 1p, de manière à la rendre optiquement inerte. Cet endommagement de la structure cristalline de la région active QW peut être réalisé par implantation d'espèces lourdes, telles que du silicium.

Le procédé de fabrication d'un dispositif photonique DP, DP' conforme aux différents modes de mise en oeuvre qui viennent d'être présentés est très similaire à un procédé de l'état de la technique.

On forme tout d'abord le guide d'onde 2 dans un substrat, de manière tout à fait conventionnelle, par des étapes de gravures, dépôt, oxydation... Cette étape peut comprendre le report du guide d'onde 2 d'un substrat de départ vers le substrat S qui servira alors à former le dispositif photonique. Alternativement, le guide d'onde 2 peut être formé directement dans ce substrat S.

Sur le substrat S dans lequel réside le guide d'onde 2, on transfère en recouvrement de ce guide d'onde 2, une vignette constituée d'un empilement formé d'une couche de matériau semi-conducteur de type N, d'une couche active, et d'une couche en matériau semi-conducteur de type P. Cette vignette est destinée à former la structure émettrice du dispositif photonique. La couche de matériau semi-conducteur de type P présente donc une épaisseur sensiblement égale à celle des piliers de type P du dispositif photonique visé, par exemple inférieur à 1 micron, ou à 500nm. D'une manière générale, la vignette présente une faible épaisseur, inférieure à deux microns.

La vignette forme un pavé de ces couches empilées, et elle est disposée sur le substrat S en recouvrement du guide d'onde 2, la couche de matériau semi-conducteur de type N étant placée du côté du guide d'onde 2. On peut prévoir qu'une couche d'assemblage BL soit disposée entre ce guide d'onde 2 et la couche de matériau semi-conducteur de type N.

Dans des étapes suivantes de gravures localisées, on traite cette vignette pour définir précisément la structure émettrice. A cet effet, on élimine une portion de la couche en matériau semi-conducteur de type P pour former les piliers de type P 1p et pour exposer la couche active. On élimine les portions latérales de cette couche pour définir la région active QW et exposer au moins une portion libre de la couche de matériau semi-conducteur de type N. Cette portion libre peut également être éliminée en partie pour former la couche de type N dans ses dimensions finales.

On encapsule ensuite l'ensemble par dépôt du matériau d'encapsulation qui peut ensuite être rendu plan, par exemple à l'aide d'une étape de polissage mécano-chimique. On note que la vignette présentant initialement une épaisseur relativement faible, les étapes de gravures localisées sont rapides à exécuter, la topologie de surface après ces étapes est moindre, l'épaisseur de matériau d'encapsulation nécessaire pour recouvrir la structure émettrice est réduite, et l'étape de polissage visant à rendre plane la surface finale est facilitée.

Dans des étapes complémentaires du procédé de fabrication du dispositif photonique, on réalise par gravure des évidements dans le matériau d'encapsulation que l'on emplit d'un matériau métallique afin de réaliser les premier et second plots métalliques en contact ohmique avec la portion libre de la couche de type N 1n et avec certains au moins des piliers de type P 1p.

Bien entendu l'invention n'est pas limitée aux modes de mise en oeuvre décrits et on peut y apporter des variantes de réalisation sans sortir du cadre de l'invention tel que défini par les revendications.

Ainsi, bien que l'on ait présenté ici des piliers en matériau semi-conducteur de type P entièrement séparés les uns des autres par un matériau d'encapsulation présentant un indice optique moindre, il n'est pas nécessaire que cela soit toujours le cas. On peut ainsi prévoir que certains au moins des piliers de type P soient solidaires des piliers qui leurs sont contigus au niveau de leurs pieds, sur une partie seulement de leur hauteur. Dans tous les cas, on structure la couche de matériau semi-conducteur de type P de la vignette rapportée sur le guide d'onde pour façonner la forme du mode optique généré afin qu'il s'étende de manière privilégiée selon la direction transverse, comme cela a été présenté dans le détail dans la présente description.

## Revendications

1. Dispositif photonique (DP, DP') pour établir un rayonnement lumineux comprenant un mode optique dans un guide d'onde, le dispositif comprenant :
- un guide d'onde (2) s'étendant dans un plan selon une direction principale de propagation du mode optique ;
- une couche en matériau semi-conducteur de type N (1n) disposée en recouvrement du guide d'onde (2) ;
- une région active (QW) formée d'un empilement de couches en matériaux III-V, la région active (QW) étant disposée sur, et en contact avec, une portion de la couche de type N (1n) au droit d'une portion (2h) du guide d'onde, une autre portion de la couche de type N, dite portion libre, n'étant pas en contact avec la région active (QW) ;
- une pluralité de piliers en matériau semi-conducteur de type P (1p, 1'p) disposés sur, et en contact avec, la région active (QW), le matériau semi-conducteur de type P présentant un premier indice optique et les piliers de type P (1p, 1'p) étant séparés les uns des autres par un matériau d'encapsulation présentant un deuxième indice optique, inférieur au premier ;
- au moins un premier plot métallique (3n, 3'n) en contact ohmique avec la portion libre de la couche de type N (1n) et au moins un second plot métallique (3p, 3'p) en contact ohmique avec les piliers de type P (1p, 1'p).

2. Dispositif photonique (DP, DP') selon la revendication précédente dans lequel le guide d'onde (2) est configuré pour former une structure de rétroaction optique.

3. Dispositif photonique (DP, DP') selon la revendication précédente dans lequel la structure de rétroaction optique est un réseau de Bragg à corrugation latérale ou à corrugation verticale.

4. Dispositif photonique (DP, DP') selon l'une des revendications précédentes comprenant une couche d'assemblage (BL) en un matériau diélectrique disposée entre la couche de type N (1n) et le guide d'onde (2).

5. Dispositif photonique (DP, DP') selon l'une des revendications précédentes comprenant au moins trois piliers de type P (1p, 1'p) .

6. Dispositif photonique (DP, DP') selon la revendication précédente dans lequel au moins un des piliers de type P (1p, 1'p) n'est pas en contact ohmique avec un second plot métallique (3p, 3'p).

7. Dispositif photonique (DP, DP') selon l'une des revendications précédentes dans lequel le matériau d'encapsulation comprend de l'air, du dioxyde de silicium, du nitrure de silicium ou de l'oxyde d'aluminium.

8. Dispositif photonique (DP, DP') selon l'une des revendications précédentes dans lequel les piliers de type P présentent des largeurs différentes ou sont séparés latéralement les uns des autres par des espacements différents.

9. Dispositif photonique (DP, DP') selon l'une des revendications précédentes dans lequel un pilier de type P (1p, 1'p) est disposé au droit d'une zone latéralement centrée de la région active (QW).

10. Dispositif photonique (DP, DP') selon l'une des revendications précédentes dans lequel les piliers de type P (1p, 1'p) présentent une hauteur inférieure à 1 micron.

11. Dispositif photonique (DP, DP') selon l'une des revendications précédentes dans lequel la couche active (QW) présente une largeur comprise entre 0,5 et 5 microns.

12. Dispositif photonique (DP, DP') selon l'une des revendications précédentes comprenant deux premiers plots métalliques (3n, 3'n) disposés de part et d'autre de la région active (QW).

13. Dispositif photonique (DP, DP') selon l'une des revendications précédentes dans lequel la région active (QW) comprend une zone endommagée disposée entre deux piliers de type P (1p, 1'p).

## Patentansprüche

1. Photonische Vorrichtung (DP, DP') zum Einrichten von Lichtstrahlung, umfassend einen optischen Modus, in einem Wellenleiter, die Vorrichtung umfassend:
- einen Wellenleiter (2), der sich in einer Ebene entlang einer Hauptausbreitungsrichtung des optischen Modus erstreckt;
- eine Schicht (1n) aus Halbleitermaterial des Typs N, die mit dem Wellenleiter (2) überlappend angeordnet ist;
- einen aktiven Bereich (QW), der aus einem Stapel von Schichten aus Materialien III-V ausgebildet ist, wobei der aktive Bereich (QW) auf einem Abschnitt der Schicht (1n) des Typs N unter einem Abschnitt (2h) des Wellenleiters angeordnet ist und diesen berührt, wobei ein anderer Abschnitt der Schicht des Typ N, der als freier Abschnitt bezeichnet wird, nicht in Kontakt mit dem aktiven Bereich (QW) steht;
- eine Vielzahl von Säulen (1p, 1'p) aus Halbleitermaterial eines Typs P, die auf dem aktiven Bereich (QW) angeordnet sind und mit diesem in Kontakt stehen, wobei das Halbleitermaterial des Typs P einen ersten optischen Index aufweist und die Säulen (1p, 1'p) des Typs P durch ein Einkapselungsmaterial voneinander getrennt sind, das einen zweiten optischen Index aufweist, der kleiner als der erste ist;
- mindestens ein erstes Metallklötzchen (3n, 3'n) in ohmschem Kontakt mit dem freien Abschnitt der Schicht (1n) des Typs N und mindestens ein zweites Metallklötzchen (3p, 3'p) in ohmschem Kontakt mit den Säulen (1p, 1'p) des Typs P.

2. Photonische Vorrichtung (DP, DP') nach dem vorstehenden Anspruch, wobei der Wellenleiter (2) konfiguriert ist, um eine Struktur für eine optische Rückkopplung auszubilden.

3. Photonische Vorrichtung (DP, DP') nach dem vorstehenden Anspruch, wobei die Struktur für die optische Rückkopplung ein Bragg-Gitter mit lateraler Korrugation oder mit vertikaler Korrugation ist.

4. Photonische Vorrichtung (DP, DP') nach einem der vorstehenden Ansprüche, umfassend eine Verbindungsschicht (BL) aus einem dielektrischen Material, die zwischen der Schicht (1n) des Typs N und dem Wellenleiter (2) angeordnet ist.

5. Photonische Vorrichtung (DP, DP') nach einem der vorstehenden Ansprüche, umfassend mindestens drei Säulen (1p, 1'p) des Typs P.

6. Photonische Vorrichtung (DP, DP') nach dem vorstehenden Anspruch, wobei mindestens eine der Säulen (1p, 1'p) des Typs P nicht in ohmschem Kontakt mit einem zweiten Metallklötzchen (3p, 3'p) steht.

7. Photonische Vorrichtung (DP, DP') nach einem der vorstehenden Ansprüche, wobei das Einkapselungsmaterial Luft, Siliziumdioxid, Siliziumnitrid oder Aluminiumoxid umfasst.

8. Photonische Vorrichtung (DP, DP') nach einem der vorstehenden Ansprüche, wobei die Säulen des Typs P unterschiedliche Breiten aufweisen oder durch unterschiedliche Abstände seitlich voneinander getrennt sind.

9. Photonische Vorrichtung (DP, DP') nach einem der vorstehenden Ansprüche, wobei eine Säule (1p, 1'p) des Typs P unter einer seitlich zentrierten Zone des aktiven Bereichs (QW) angeordnet ist.

10. Photonische Vorrichtung (DP, DP') nach einem der vorstehenden Ansprüche, wobei die Säulen (1p, 1'p) des Typs P eine Höhe von weniger als 1 Mikrometer aufweisen.

11. Photonische Vorrichtung (DP, DP') nach einem der vorstehenden Ansprüche, wobei die aktive Schicht (QW) eine Breite zwischen 0,5 und 5 Mikrometer aufweist.

12. Photonische Vorrichtung (DP, DP') nach einem der vorstehenden Ansprüche, umfassend zwei erste Metallklötzchen (3n, 3'n), die auf beiden Seiten des aktiven Bereichs (QW) angeordnet sind.

13. Photonische Vorrichtung (DP, DP') nach einem der vorstehenden Ansprüche, wobei der aktive Bereich (QW) einen beschädigten Bereich, der zwischen zwei Säulen (1p, 1'p) des Typs P angeordnet ist, umfasst.

## Claims

1. Photonic device (DP, DP') for providing light radiation, comprising an optical mode in a wave guide, the device comprising:
- a wave guide (2) extending in a plane in a main direction of propagation of the optical mode;
- a layer (1n) made of N-type semiconductor material arranged so as to cover the wave guide (2);
- an active region (QW) formed by a stack of layers made of III-V materials, the active region (QW) being arranged on and in contact with a portion of the N-type layer (1n) in line with a portion (2h) of the wave guide, another portion of the N-type layer, referred to as the free portion, not being in contact with the active region (QW);
- a plurality of pillars (1p, 1'p) made of P-type semiconductor material arranged on and in contact with the active region (QW), the P-type semiconductor material having a first optical index and the P-type pillars (1p, 1'p) being separated from one another by an encapsulation material having a second optical index, lower than the first;
- at least one first metal pad (3n, 3'n) in ohmic contact with the free portion of the N-type layer (1n) and at least one second metal pad (3p, 3'p) in ohmic contact with the P-type pillars (1p, 1'p).

2. Photonic device (DP, DP') according to the preceding claim, wherein the wave guide (2) is configured to form an optical feedback structure.

3. Photonic device (DP, DP') according to the preceding claim, wherein the optical feedback structure is a laterally corrugated or vertically corrugated Bragg grating.

4. Photonic device (DP, DP') according to any of the preceding claims, comprising an assembly layer (BL) made from a dielectric material arranged between the N-type layer (1n) and the wave guide (2).

5. Photonic device (DP, DP') according to any of the preceding claims, comprising at least three P-type pillars (1p, 1'p).

6. Photonic device (DP, DP') according to the preceding claim, wherein at least one of the P-type pillars (1p, 1'p) is not in ohmic contact with a second metal pad (3p, 3'p).

7. Photonic device (DP, DP') according to any of the preceding claims, wherein the encapsulation material comprises air, silicon dioxide, silicon nitride or aluminum oxide.

8. Photonic device (DP, DP') according to any of the preceding claims, wherein the P-type pillars have different widths or are laterally separated from one another by different spacings.

9. Photonic device (DP, DP') according to any of the preceding claims, wherein a P-type pillar (1p, 1'p) is arranged in line with a laterally centered zone of the active region (QW).

10. Photonic device (DP, DP') according to any of the preceding claims, wherein the P-type pillars (1p, 1'p) have a height of less than 1 micron.

11. Photonic device (DP, DP') according to any of the preceding claims, wherein the active layer (QW) has a width of between 0.5 and 5 microns.

12. Photonic device (DP, DP') according to any of the preceding claims, comprising two first metal pads (3n, 3'n) arranged on either side of the active region (QW).

13. Photonic device (DP, DP') according to any of the preceding claims, wherein the active region (QW) comprises a damaged zone arranged between two P-type pillars (1p, 1'p).
